**Europäisches Patentamt**

**European Patent Office**

**Office européen des brevets**

(19)

(11) Publication number: **0 425 954 A1**

# EUROPEAN PATENT APPLICATION

(21) Application number: 90120181.4

(22) Date of filing: 20.10.90

(51) Int. Cl.5: **H01L 41/06**

(30) Priority: 31.10.89 SE 8903632

(43) Date of publication of application:
08.05.91 Bulletin 91/19

(84) Designated Contracting States:
**DE FR GB IT**

(71) Applicant: **ABB ATOM AB**

**S-721 83 Västeras(SE)**

(72) Inventor: **Engdahl, Göran**
**Rospiggsvägen 4**
**S-183 62 Täby(SE)**
Inventor: **Wikström, Dag**
**Stalverksgatan 86**
**S-724 77 Västeras(SE)**

(74) Representative: **Boecker, Joachim, Dr.-Ing.**
**Rathenauplatz 2-8**
**W-6000 Frankfurt a.M. 1(DE)**

(54) Device for transmission of movement and compressive force.

(57) Device for transmission of movement and compressive force between a force-generating element in the form of a cylindrical body (1) and attached disc-shaped force-absorbing elements (5a,5b) via thin circular plates (4a,4b) of a material with low losses and low reluctance which are placed between the cylindrical body (1) and the elements (5a,5b). The plates (4a,4b), upon loading, are subjected to a relatively great elastic deformation with an ensuing reduced ability to transmit movement and compressive force. By perforating these plates with a number of evenly distributed holes (7) provided with pellets (8) of a stiff resistant material with an axial length of at least the thickness of the platesl these pellets take over the duty of transmitting movement and compressive force between the cylindrical body (1) the elements (5a,5b) without the plates (4a,4b) being elastically deformed.

# DEVICE FOR TRANSMISSION OF MOVEMENT AND COMPRESSIVE FORCE

The invention relates to a device for transmission of movement and compressive force according to the precharacterising part of claim 1.

Certain parts of such a device may be subjected to high stresses of various kinds, depending on the prupose of the design. The possibilities available for ensuring that the stressses do not jeopardize the function of the device depend on several factors such as, for example, the material in question, the nature and frequency of the stress, the environment, etc. A device according to the invention is intended to be used when a compressive stress directed against a plate may become of such a magnitude that the function of the device may be jeopardized or considerably deteriorated.

US-A-4,914,412 relates to a specifically designed magnetic circuit which, inter alia, comprises driving elements of a material with high-magnetostrictive properties, for example Terfenol. The magnetic material which is to be magnetized is in the shape of a cylindrical body. It is surrounded by a magnetizing coil which has the same axial length as the cylindrical body. The two plane surfaces which are formed by the end surfaces of the cylindrical body and the end surfaces of the coil are covered by relatively thin circular plates having the same outside diameters as the coil and are manufactured from a soft-magnetic material.

The magnetic circuit is magnetized statically by means of permanent magnets which are formed as discs having the same diameter as the soft-magnetic plates. They are arranged on top of the soft-magnetic plates. The magnetic circuit finally comprises a cylindrical ring of ferromagnetic material which surrounds the coil and has the same axial length as the coil.

Since as mentioned above the cylindrical body is made of high-magnetostrictive material, i.e. with a great coefficient of linear expansion when subjected to a magnetic field, the compressive stresses on the circular plates may become considerable. Since otherwise the magnetic circuit has a high dynamic performance, also fatigue problems may arise in connection with a high mechanical load.

From a magnetic point of view, it is important that the circular plates have a reluctance as low as possible and that the eddy currents and hysteresis losses occurring therein are also as low as possible. One suitable material from these points of view is therefore, for example, a pressed powder mixture of soft-magnetic particles and plastic particles. It is then obvious that the mechanical loadability becomes restricted. If the material is subjected, for example, to a high compressive stress within the elastic range, this will result in a considerable elastic deformation, i.e. the compressive stress from the cylindrical body will be capable of being transmitted only to an insignificant extent to an external mechanical load. If the compressive stress results in a load on the material which exceeds the elastic range, the material will be pulverized. From a mechanical point of view, therefore, such a material is less suitable.

The invention aims at providing a device for the transmis sion of movement and compressive force of the above-mentioned kind, which device ensures good magnetic properties (low reluctance, low eddy currents and low hysteresis losses) of said circular plates of soft magnetic material while at the same time protecting these plates from unwanted elastic deformation or even destruction under operation of the device.

To achieve this aim the invention suggests a device for transmission of movement and compressive force according to the introductory part of claim 1, which is characterized by the features of the characterizing part of claim 1.

Further developments of the invention are characterized by the features of the additional claims.

The invention comprises a special embodiment of the circular plates which permits movement and compressive stresses both of a static and of dynamic nature, which arise in connection with changes of length of the cylindrical body, to be transmitted to the external mechanical load without the circular plates being compressed. This is achieved by perforating the circular plates with a number of evenly distributed, preferably circular-cylindrical holes in that part of the plates which covers to the end surface of the cylindrical body. In these holes are placed pellets of a resistant material with a high modulus of elasticity. To keep the magnetic losses low, the pellets should preferably be made of a ceramic material. The pellets are dimensioned radially so as to be easily movable in an axial direction. In the axial direction the pellets shall be dimensioned so as to have a length which at least corresponds to the thickness of the circular plates in unloaded state.

The perforation increases the reulctance of the circular plates. To prevent too large an increase, it is desirable for the fill factor - i.e. how large a portion of the available surface of said central part of the circular plates is covered by the perforating holes - not to become too great.

From a magnetic point of view, it is desirable to have a large number of small holes. However, this also requires an equally large number of pellets with small cross section areas. However, from the points of view of manufacturing, assembly and cost, this is a disadvantage.

To cause each of the pellets to transmit an equally great part of the movement and compressive force from the circular-cylindrical body to the permanent magnets, it is required that the pellets have an exactly equally great axial length. A difference between the pellets in this respect means that both the circular-cylindrical body and the permanent-magnetic discs partially may be subjected to relatively high stresses. To obtain a more even pressure distribution across the end surfaces of the cylindrical body, there may be introduced a pressure-equalizing plate of a ceramic material with the same diameter as that of the cylindrical body between the end surfaces of the cylindrical body and the two circular plates.

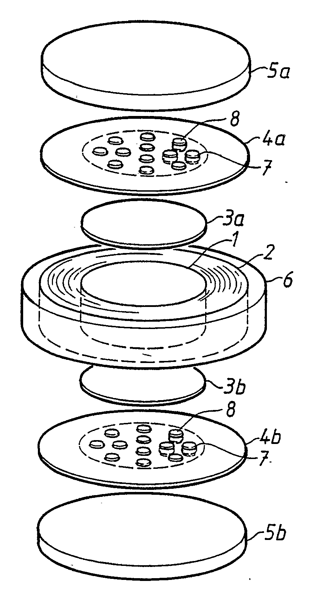

By way of example, the invention will now be described in greater detail with reference to the accompanying drawing.

The only Figure shows a device according to the invention comprising a magnetic circuit similar to that described in US-A-4,914,412. To provide a clearer illustration, the parts included are represented in axially displacement relative to each other. The device comprises a cylindrical body 1 of high-magnetostrictive material. It is surrounded by a magnetizing coil 2. As will be clear from the description, pressure-equalizing plates 3a and 3b are inserted between the end surfaces of the cylindrical body 1 and plane circular plates 4a and 4b, which cover the cylindrical body 1 with the surrounding coil 2. External force-absorbing permanentmagnetic discs are shown at 5a and 5b, and a surrounding ferromagnetic ring is shown at 6.

The invention comprises a modification of the circular plates 4a and 4b to prevent elastic deformation thereof and hence a deteriorated transmission of movement and compressive force between the cylindrical body 1 and the permanentmagnetic discs 5a and 5b. The modification comprises the provision of a number of evenly distributed holes 7 in the central part of the thin circular plates said central part corresponding to the end surfaces of the cylindrical body 1. A suitable fill factor according to the definition above lies within the range of 0.1 to 0.7. The holes preferably have a circular-cylindrical shape although other shapes are possible. For reasons described above, a suitable ratio of the diameter of the holes to the diameter of the cylindrical body may be between 0.05 and 0.5.

The pellets 8, which are made of a resistant, preferably ceramic material, are placed in the holes of the plates 4a and 4b. The radial fit between the cylindrical surface of the holes and the cylindrical surface of the pellets shall be such as to allow easy axial movability of the pellets in the holes of the circular plates 4a and 4b. Finally, as mentioned, the axial length of the pellets shall be at least as great as the thickness of the circular plates in unloaded state.

## Claims

1. Device for transmission of movement and compressive force between a force-generating element in the form of a preferably cylindrical body (1) and an attached force- absorbing element (5a, 5b), making force-transmitting contact therewith, in the form of discs, which device comprises circular thin plates (4a,4b) of a low-loss softmagnetic material which are placed between the cylindrical body (1) and the force-absorbing elements (5a,5b), **characterized** in that in part of the plates (4a,4b), which part corresponds to the end surface of the cylindrical body, a number of preferably evenly distributed holes (7) are provided, into which are positioned easily axially displaceable pellets (8) of a stiff and resistant material.

2. Device according to claim 1, **characterized** in that between the end surfaces of the cylindrical body (1) and the thin circular plates (4a,4b) there are provided pressure-equalizing plates (3a,3b) of a ceramic material with the same diameter as the end surface of the cylindrical body.

3. Device according to claim 1 or 2, **characterized** in that the axial length of the pellets is at least as great as the thickness of the plates (4a,4b) in unloaded state.

4. Device according to any of the preceding claims, **characterized** in that the ratio between the total area occupied by said holes (7) and the end surface of the cylindrical body is within the range of 0.1 to 0.7.

5. Device according to any of the preceding claims, **characterized** in that the holes have a preferably cylindrical shape.

6. Device according to any of the preceding claims, **characterized** in that the ratio between the diameter of the holes and the diameter of the cylindrical body shall lie within the range of 0.05 to 0.5.

## DOCUMENTS CONSIDERED TO BE RELEVANT

| Category | Citation of document with indication, where appropriate, of relevant passages | Relevant to claim | CLASSIFICATION OF THE APPLICATION (Int Cl⁵) |
|---|---|---|---|
| A | EP-A2-0 251 468 (RAYTHEON COMPANY)  <br> --- | 1 | H 01 L 41/06 |
| A | EP-A1-0 283 880 (ASEA BROWN BOVERI AB)  <br> --- | 1 | |
| A | WO-A1-86/03888 (GOULD INC)  <br> ----- | 1 | |

**TECHNICAL FIELDS SEARCHED (Int Cl⁵)**

B 06 B
H 01 F
H 01 L
H 01 V
H 04 R

The present search report has been drawn up for all claims

| Place of search | Date of completion of the search | Examiner |
|---|---|---|
| STOCKHOLM | 17-12-1990 | WESTÖÖ M. |